(19) Europäisches Patentamt
European Patent Office
Office européen des brevets

(11) **EP 2 530 514 A1**

(12) **EUROPEAN PATENT APPLICATION**

(43) Date of publication:
**05.12.2012 Bulletin 2012/49**

(51) Int Cl.:
**G02F 1/1335** (2006.01)   **G02B 3/00** (2006.01)
**H01L 51/52** (2006.01)

(21) Application number: **12169800.5**

(22) Date of filing: **29.05.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **30.05.2011 KR 20110051584
22.06.2011 KR 20110060522**

(71) Applicant: **Samsung Corning Precision Materials
Co., Ltd.
Gyeongsangbuk-do
Gumi-si, 730-735 (KR)**

(72) Inventors:
• **Park, Seong Sik
336-841 Asan-si, ChungCheongNam-Do (KR)**
• **Kim, Euisoo
336-841 Asan-si ChungCheongNam-Do (KR)**
• **Kim, Joosok
336-841 Asan-si ChungCheongNam-Do (KR)**
• **Shin, You Min
336-841 Asan-si ChungCheongNam-Do (KR)**
• **Lee, Jinhoon
336-841 Asan-si ChungCheongNam-Do (KR)**
• **Cho, Eun Young
336-841 Asan-si ChungCheongNam-Do (KR)**

(74) Representative: **Gulde Hengelhaupt Ziebig &
Schneider
Patentanwälte - Rechtsanwälte
Wallstrasse 58/59
10179 Berlin (DE)**

(54) **Display device comprising an optical film having a lens pattern**

(57)    A display device (1) that can reduce color shift and prevent the quality of an image from degrading due to Moiré. The display device includes a display panel (5) and an optical film (10), which includes a background layer (11) disposed in front of the display panel (5), and a lens section (12) formed on the background layer (11). The lens section (12) has a plurality of engraved or raised patterns (12a) spaced apart from each other to diffuse incident light. The spacing ($_T$) between the plurality of engraved or raised patterns (12a) and a pitch (T) of the plurality of engraved or raised patterns (12a) satisfy the following conditions (1) to (3):

$$(1) \qquad \left| 2\frac{\sin(\pi \cdot k \cdot p/P)\,\sin(\pi \cdot m \cdot p/P)}{(\pi \cdot k \cdot p/P)\,(\pi \cdot m \cdot p/P)} \right| \le 0.01,$$

$$(2) \qquad k = \frac{\tau/T}{p/P},$$

and

$$(3) \qquad m = P/T,$$

wherein P is a pitch of the sub-pixels and p is a width of the sub-pixels.

**(Cont. next page)**

# FIG. 1

## Description

### CROSS REFERENCE TO RELATED APPLICATION

The present application claims priority from Korean Patent Application Numbers 10-2011-0051584 filed on May 30, 2011 and 10-2011-0060522 filed on June 22, 2011, the entire contents of which applications are incorporated herein for all purposes by this reference.

### BACKGROUND OF THE INVENTION

### Field of the Invention

The present invention relates to a display device, and more particularly, to a display device that can not only reduce color shift but also prevent the quality of an image from degrading due to a moiré phenomenon.

### Description of Related Art

In response to the emergence of the advanced information society, components and devices related to image displays have been significantly improved and rapidly disseminated. Among them, image display devices have been widely distributed for use in TVs, personal computer (PC) monitors, and the like. Moreover, attempts are underway to simultaneously increase the size and reduce the thickness of such display devices.

In general, a liquid crystal display (LCD) is one type of flat panel display, and displays images using liquid crystals. LCDs are widely used throughout industries since they have the advantages of light weight, low drive voltage and low power consumption compared to other display devices.

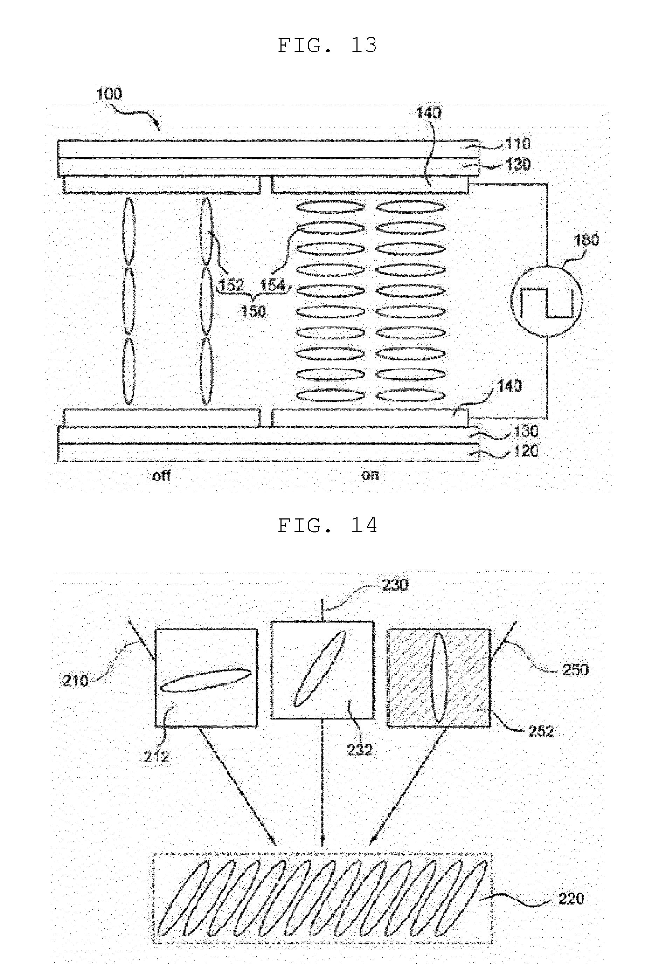

FIG. 13 is a conceptual view schematically showing the basic structure and operating principle of an LCD 100. With reference by way of example to a conventional vertical alignment (VA) LCD, two polarizer films 110 and 120 are arranged such that their optical axes are oriented perpendicular to each other. Liquid crystal molecules 150 having birefringence characteristics are interposed and arranged between two transparent substrates 130, which are coated with transparent electrodes 140. When an electric field is applied from a power supply unit 180, the liquid crystal molecules move and are aligned perpendicular to the electric field.

Light emitted from a backlight unit is linearly polarized after passing through the first polarizer film 120. As shown in the left of FIG. 13, the liquid crystal molecules remain perpendicular to the substrates when no power is applied. As a result, light that is in a linearly polarized state is blocked by the second polarizer film 110, the optical axis of which is perpendicular to that of the first polarizer film 120.

In the meantime, as shown in the right of FIG. 13, when power is on, the electric field causes the liquid crystal molecules to become horizontally aligned such that they are parallel to the substrates, between the two orthogonal polarizer films 110 and 120. Thus, the linearly polarized light from the first polarizer film is converted into another kind of linearly polarized light, the polarization of which is rotated by 90°, circularly polarized light, or elliptically polarized light while passing through the liquid crystal molecules before it reaches the second polarizer film. The converted light is then able to pass through the second polarizer film. It is possible to gradually change the orientation of the liquid crystal from the vertical orientation to the horizontal orientation by adjusting the intensity of the electric field, thereby allowing control of the intensity of light emission.

FIG. 14 is a conceptual view showing the orientation and optical transmittance of liquid crystals depending on the viewing angle.

When liquid crystal molecules are aligned in a predetermined direction within a pixel 220, the orientation of the liquid crystal molecules varies depending on the viewing angle.

When viewed from the front left (210), the liquid crystal molecules look as if they are substantially aligned along the horizontal orientation 212, and the screen is relatively bright. When viewed from the front along the line 230, the liquid crystal molecules are seen as being aligned along the orientation 232, which is the same as the orientation inside the pixel 220. In addition, when viewed from the front left (250), the liquid crystal molecules look as if they are substantially aligned along the vertical orientation 252, and the screen is somewhat darker.

Accordingly, the viewing angle of the LCD is greatly limited compared to other displays, which intrinsically emit light, since the intensity and color of light of the LCD varies depending on changes in the viewing angle. A large amount of research has been carried out with the aim of increasing the viewing angle.

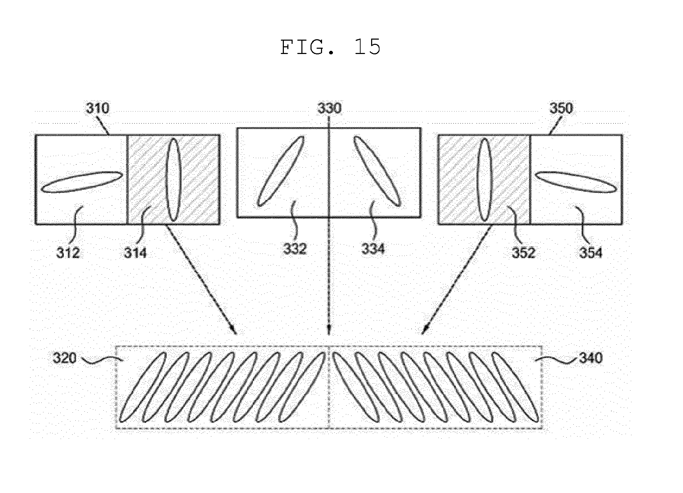

FIG. 15 is a conceptual view showing a conventional attempt to reduce variation in the contrast ratio and color shift depending on the viewing angle.

Referring to FIG. 15, a pixel is divided into two pixel parts, that is, first and second pixel parts 320 and 340, in which the orientations of liquid crystals are symmetrical to each other. Either the liquid crystals oriented as shown in the first pixel part 320 or the liquid crystals oriented as shown in the second pixel part 340 can be seen, depending on the viewing direction of a viewer. The intensity of light reaching the viewer is the total intensity of light of the two pixel parts.

When viewed from the front left (310), liquid crystal molecules in the first pixel part 320 look as if they are aligned along the horizontal orientation 312, and liquid crystal molecules in the second pixel part 320 look as if they are aligned along the vertical orientation 314. Thus, the first pixel part 320 makes the screen look bright. Likewise, when viewed from the front right (350), the liquid crystal molecules in the first pixel part 320 look as if they are aligned along the vertical orientation 352, and the liquid crystal molecules in the second pixel part 340 look as if they are aligned along the horizontal orientation 354. Then, the second pixel part 340 can make the screen look bright. In addition, when viewed from the front, the liquid crystal molecules are seen to be aligned along the orientations 332 and 334, which are the same as the orientations inside the pixel parts 320 and 340. Accordingly, the brightness of the screen observed by the viewer remains the same or similar, and is symmetrical about the vertical center line of the screen, even when the viewing angle changes. This, as a result, makes it possible to reduce variation in the contrast ratio and color shift depending on the viewing angle.

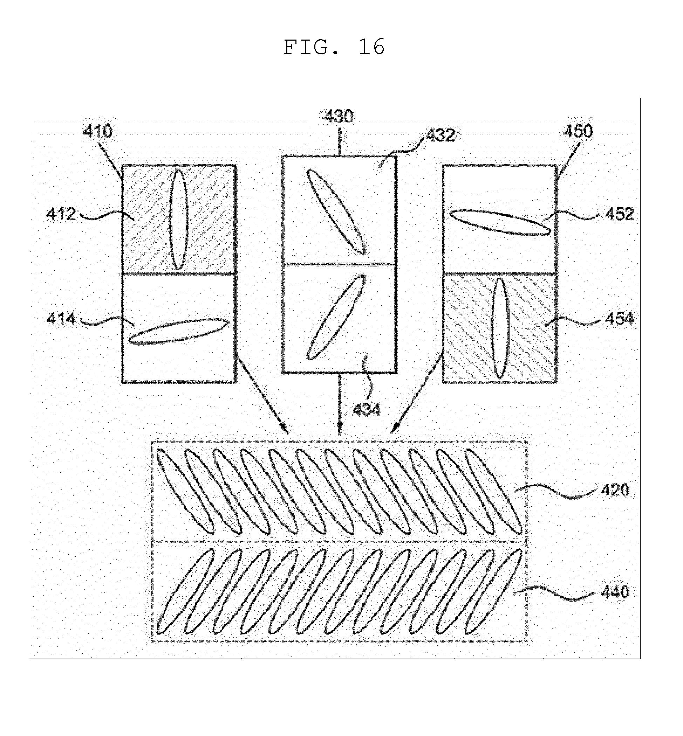

FIG. 16 is a conceptual view showing another conventional approach for reducing variation in the contrast ratio and color shift depending on to the viewing angle.

Referring to FIG. 16, an optical film 420 having birefringence characteristics is added. The birefringence characteristics of the optical film 420 are the same as those of liquid crystal molecules inside a pixel 440 of an LCD panel, and are symmetrical with the orientation of the liquid crystal molecules. Due to the orientation of the liquid crystal molecules inside the pixel 440 and the birefringence characteristics of the optical film, the intensity of light reaching the viewer is the total intensity of light from the optical film 420 and the pixel 440.

Specifically, when viewed from the front left (410), the liquid crystal molecules inside the pixel 440 look as if they are aligned along the horizontal orientation 414, and the imaginary liquid crystals produced by the optical film 420 look as if they are aligned along the vertical orientation 412. The resultant intensity of light is the total intensity of light from the optical film 420 and the pixel 440. Likewise, when viewed from the front right (450), the liquid crystal molecules inside the pixel 440 look as if they are aligned along the vertical orientation 454 and the imaginary liquid crystals produced by the optical film 420 look as if they are aligned along the horizontal orientation 452. The resultant intensity of light is the total intensity of light from the optical film 420 and the pixel 440. In addition, when viewed from the front, the liquid crystal molecules are seen to be aligned along the orientations 434 and 432, which are the same as the orientation inside the pixel 440 and the double-refracted orientation of the optical film 420, respectively.

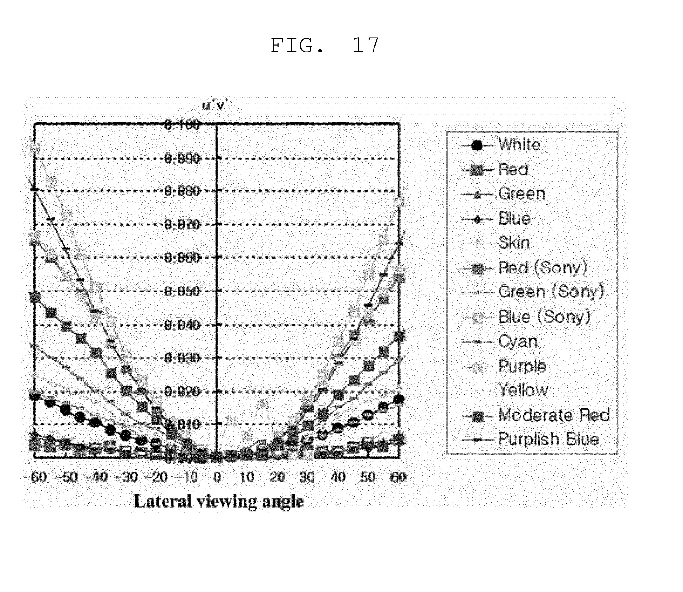

However, even if the approaches described above are applied, as shown in FIG. 17, color shift still occurs depending on the viewing angle, and the color changes when the viewing angle increases.

In the meantime, organic light-emitting displays are divided into a passive matrix type display and an active matrix type display depending on the method of driving an N×M number of pixels, which are arrayed in the form of a matrix.

Here, in the case of the active matrix type, a pixel electrode, which defines a light-emitting area, and a unit pixel drive circuit, which applies current or a voltage to the pixel electrode, are positioned in each unit pixel area. The unit pixel drive circuit is provided with at least one thin-film transistor (TFT), through which a constant level of current can be supplied irrespective of the number of pixels so that luminance can be expressed reliably. This active matrix type organic light-emitting display has a merit in that it can be advantageously applied to high resolution and large displays, since it consumes a small amount of power.

However, the organic light-emitting display has the problem of low out-coupling efficiency. In an example, an organic light-emitting display that has not undergone additional processing can emit only about 20% of light that is generated from an organic light-emitting layer.

Here, the light efficiency is determined by the refractive indexes of the constitutional layers from the organic light-emitting layer to the exterior of the organic light-emitting display, which employs the organic light-emitting layer. One of factors that decrease the light efficiency is the presence of light that exits in an unnecessary direction when emitted from the substrate having a higher refractive index to the air having a lower refractive index. In addition, when the angle at which light is incident on the interface between the substrate and the air is equal to or greater than the critical angle, the light is totally reflected, thereby reducing the external light extraction.

In order to solve the light efficiency problem of the organic light-emitting display, a micro-cavity structure was proposed. The micro-cavity structure is designed such that the distance between the anode and the cathode matches the respective major wavelength of red (R) light, green (G) light and blue (B) light, so that only the corresponding light resonates and exits to the outside, but the other light is weakened. As a result, the strength and the sharpness of light that is emitted are increased, thereby advantageously increasing luminance. The increased luminance results in low power consumption, which leads to an increase in longevity. Here, the increased sharpness of radiating light means that color purity is improved and thus color reproducing ability is increased.

However, in addition to the above advantage, the organic light-emitting display having the micro-cavity structure has the drawback of the decreased viewing angle due to color shift. This is because an optical path changes at a side, i.e. a high angle, and the wavelength of light that can resonate varies. This consequently causes a problem in that the light that resonates and exits is further shifted to a short wavelength as the optical path is increased at the side.

The information disclosed in this Background of the Invention section is only for the enhancement of understanding of the background of the invention, and should not be taken as an acknowledgment or any form of suggestion that this information forms a prior art that would already be known to a person skilled in the art.

**BRIEF SUMMARY OF THE INVENTION**

Various aspects of the present invention provide a display device that can reduce not only color shift but also degradation in image quality due to a moiré phenomenon.

In an aspect of the present invention, provided is a display device that includes a display panel and an optical film. The optical film includes a background layer disposed in front of the display panel; and a lens section formed on the background layer, the lens section having a plurality of engraved or raised patterns spaced apart from each other in order to diffuse incident light. The patterns have a spacing and a pitch, which are determined by the following m value deduced from the following formulae that are derived from Fourier series:

$$\frac{I_{\max} - I_{\min}}{I_{\max} + I_{\min}} \approx \left|2 \frac{\sin(\pi \cdot k \cdot p/P)}{(\pi \cdot k \cdot p/P)} \frac{\sin(\pi \cdot m \cdot p/P)}{(\pi \cdot m \cdot p/P)}\right| \leq 0.01 \quad ,$$

$$k = \frac{\tau/T}{p/P} \quad ,$$

and

$$m = P/T \quad ,$$

where $\tau$ is the spacing between the patterns, T is the pitch of the patterns, p/P is an aperture ratio of sub-pixels that form the display panel, $\tau$/T is an aperture ratio of the lens section, I is an intensity of light that exits the optical film after entering the optical film from the sub-pixels, P is a pitch of the sub-pixels, p is a width of the sub-pixels, T is a pitch of the patterns, and $\tau$ = T-W.

Here, the term $\frac{I_{\max} - I_{\min}}{I_{\max} + I_{\min}}$ is the modulation value of the intensity I, and characteristics of the optical film are determined by the m value when this term is 0.01 or less. When the aperture ratio of the sub-pixels of the panel and the aperture ratio of the optical film are determined, the spacing $\tau$ and the pitch T of patterns of the optical film are determined.

In an exemplary embodiment of the invention, the display device may further include a resin filling the lens section, the resin having a refractive index different from the refractive index of the background layer.

In an exemplary embodiment of the invention, the refractive index of the background layer may be smaller than the refractive index of the resin.

In an exemplary embodiment of the invention, the difference between the refractive index of the background layer and the refractive index of the resin may be 0.1 or greater.

In an exemplary embodiment of the invention, the display device further includes a resin layer coating the lens section and a surface of the background layer on which the lens section is formed.

In an exemplary embodiment of the invention, the resin may be disposed in concave portions of the engraved patterns.

In an exemplary embodiment of the invention, the resin may be disposed in a space between the raised patterns.

In an exemplary embodiment of the invention, the background layer may be made of a transparent polymer material.

In an exemplary embodiment of the invention, the background layer may be in close contact with the front surface of the display panel.

In an exemplary embodiment of the invention, the background layer may be made of a material that has an adhesive property, and may be directly attached to the front surface of the display panel.

In an exemplary embodiment of the invention, the background layer may be made of a transparent elastomer.

In an exemplary embodiment of the invention, the background layer may be adhered to the front surface of the display panel by an adhesive.

In an exemplary embodiment of the invention, the lens section may be formed on one surface or both surfaces of the background layer.

Preferably the lens section is formed on a rear surface of the background layer that faces the display panel.

In an exemplary embodiment of the invention, the cross-section of the patterns may have a shape including an arc of an ellipse.

In an exemplary embodiment of the invention, the patterns may have a shape selected from the group consisting of stripes having a wedge-shaped cross-section, waves having a wedge-shaped cross-section, a matrix having a wedge-shaped cross-section, a honeycomb having a wedge-shaped cross-section, dots having a wedge-shaped cross-section, stripes having a quadrangular cross-section, waves having a quadrangular cross-section, a matrix having a quadrangular cross-section, a honeycomb having a quadrangular cross-section, dots having a quadrangular cross-section, stripes having a semicircular cross-section, waves having a semicircular cross-section, a matrix having a semicircular cross-section, a honeycomb having a semicircular cross-section, dots having a semicircular cross-section, stripes having a semi-elliptical cross-section, waves having a semi-elliptical cross-section, a matrix having a semi-elliptical cross-section, a honeycomb having a semi-elliptical cross-section, dots having a semi-elliptical cross-section, stripes having a semi-oval cross-section, waves having a semi-oval cross-section, a matrix having a semi-oval cross-section, a honeycomb having a semi-oval cross-section, and dots having a semi-oval cross-section.

In an exemplary embodiment of the invention, the spacing between the plurality of patterns may be greater than the width of each pattern.

In an exemplary embodiment of the invention, the ratio of the depth to the width of each pattern ranges from 0.25 to 2.5.

In an exemplary embodiment of the invention, the ratio of the spacing to the pitch of the patterns may range from 0.5 to 0.95.

In an exemplary embodiment of the invention, the pitch of the patterns may be 45μm or less.

In an exemplary embodiment of the invention, the display device may further include a backing, which is disposed on the front surface of the background layer to support the background layer.

In an exemplary embodiment of the invention, the display device may further include an anti-reflection layer formed on the front surface of the backing.

Preferably the display panel is a liquid crystal display panel, which comprises two opposing substrates and a liquid crystal layer interposed between the two opposing substrates. Preferably the display panel is an organic light-emitting display panel, which comprises organic light-emitting devices, each of the organic light-emitting devices generates one of red light, green light, blue light and white light, and the organic light-emitting device are formed at different heights depending on respective wavelengths of lights which the organic light-emitting devices generate.

Preferably, the plurality of engraved or raised patterns is uniformly arranged on the background layer. Preferably, the plurality of engraved or raised patterns is arranged on the background layer in a regular pattern. Preferably, each of the plurality of engraved or raised patterns has a uniform shape. Preferably, each of the plurality of engraved or raised patterns has a uniform size. Preferably, each of the plurality of engraved or raised patterns has a uniform width. Preferably, the spacing between the plurality of engraved or raised patterns is uniform. In another aspect of the invention, provided is display device that includes a liquid crystal display panel, which includes two opposing substrates and a liquid crystal layer interposed between the two opposing substrates; and an optical film. The optical film includes a background layer disposed in front of the display panel and a lens section formed on the background layer. The lens section has a plurality of engraved or raised patterns spaced apart from each other in order to diffuse incident light. The patterns have a spacing and a pitch, which are determined by the following m value deduced from the following formulae that are derived from Fourier series:

$$\frac{I_{max} - I_{min}}{I_{max} + I_{min}} \approx \left| 2 \frac{\sin(\pi \cdot k \cdot p/P)}{(\pi \cdot k \cdot p/P)} \frac{\sin(\pi \cdot m \cdot p/P)}{(\pi \cdot m \cdot p/P)} \right| \leq 0.01,$$

$$k = \frac{\tau/T}{p/P},$$

and

$$m = P/T,$$

where $\tau$ is the spacing between the patterns, T is the pitch of the patterns, p/P is an aperture ratio of sub-pixels that form the display panel, $\tau$/T is an aperture ratio of the lens section, I is an intensity of light that exits the optical film after being diffused through the sub-pixels, P is a pitch of the sub-pixels, p is a width of the sub-pixels, T is a pitch of the patterns, and $\tau$ = T-W.

In a further aspect of the invention, provided is display device that includes an organic light-emitting display panel, which includes organic light-emitting devices, each of which generates one of red light, green light, blue light and white light, and which are formed at different heights depending on respective wavelengths; and an optical film. The optical film includes a background layer disposed in front of the display panel and a lens section formed on the background layer. The lens section has a plurality of engraved or raised patterns spaced apart from each other in order to diffuse incident light. The patterns have a spacing and a pitch, which are determined by the following m value deduced from the following formulae that are derived from Fourier series:

$$\frac{I_{max} - I_{min}}{I_{max} + I_{min}} \approx |2\frac{\sin(\pi \cdot k \cdot p/P)}{(\pi \cdot k \cdot p/P)}\frac{\sin(\pi \cdot m \cdot p/P)}{(\pi \cdot m \cdot p/P)}| \leq 0.01,$$

$$k = \frac{\tau/T}{p/P},$$

and

$$m = P/T,$$

where $\tau$ is the spacing between the patterns, T is the pitch of the patterns, p/P is an aperture ratio of sub-pixels that form the display panel, $\tau$/T is an aperture ratio of the lens section, I is an intensity of light that exits the optical film after being diffused through the sub-pixels, P is a pitch of the sub-pixels, p is a width of the sub-pixels, T is a pitch of the patterns, and $\tau$ = T-W.

In an exemplary embodiment of the invention, the lens section may be formed on the rear surface of the background layer that faces the organic light-emitting display panel.

According to embodiments of the invention, it is possible to improve image quality by minimizing color shift due to an increase in the viewing angle and to prevent the image quality from being degraded by the moiré phenomenon by calculating an optimum parameter for a pattern pitch and applying the optimum parameter.

In addition, according to embodiments of the invention, it is possible to reduce ghosting and hazing by directly attaching the optical film to the display panel or bringing the optical film into contact with the display panel via adhesion.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

**BRIEF DESCRIPTION OF THE DRAWINGS**

FIG. 1 is a conceptual view depicting a display device that has an optical film according to an exemplary embodiment of the invention and the front transmittance of the optical film;

FIG. 2 is a cross-sectional view schematically showing a display device that has an optical film according to an exemplary embodiment of the invention, in which the background layer is attached to a display panel via an adhesive;

FIG. 3 is a cross-sectional view schematically showing a display device that has an optical film according to an exemplary embodiment of the invention, in which a lens section is formed in the front surface of a background layer;

FIG. 4 is a cross-sectional view schematically showing a display device that has an optical film according to an exemplary embodiment of the invention, in which a lens section is formed in both surfaces of a background layer;

FIG. 5 is a cross-sectional view schematically showing a display device that has an optical film according to an exemplary embodiment of the invention, in which a raised lens section is formed on a background layer;

FIG. 6 is a graph depicting the front transmittance of an optical film according to an exemplary embodiment of the invention using the Fourier series;

FIG. 7 and FIG. 8 are graphs showing modulation values of the intensity of light depending on variation in a 'm' value of a formula derived from the Fourier series with respect to an optical film according to an exemplary embodiment of the invention;

FIG. 9 is a picture showing an optical film (a) according to a comparative example and an optical film (b) according to an example of the invention, which are attached to a display panel;

FIG. 10 is a picture showing a moiré phenomenon;

FIG. 11 is a cross-sectional view schematically showing a display device that has an optical film according to an exemplary embodiment of the invention, in which a backing and an antireflection layer are formed on the front surface of the background layer;

FIG. 12 is a configuration view schematically showing an organic light-emitting display device that has an optical film according to an exemplary embodiment of the invention;

FIG. 13 is a conceptual view schematically showing the basic structure and operating principle of a liquid crystal display (LCD);

FIG. 14 is a conceptual view showing the orientation and optical transmittance of liquid crystals depending on the viewing angle;

FIG. 15 is a conceptual view showing a conventional attempt to reduce variation in the contrast ratio and color shift depending on the viewing angle;

FIG. 16 is a conceptual view showing another conventional attempt to reduce variation in the contrast ratio and color shift depending on the viewing angle; and

FIG. 17 is a graph showing color shift depending on the viewing angle for an LCD on which an optical film of the present invention is not mounted.

## DETAILED DESCRIPTION OF THE INVENTION

Reference will now be made in detail to an optical film and a display device having the optical film according to the invention, embodiments of which are illustrated in the accompanying drawings and described below.

In the following description of the present invention, detailed descriptions of known functions and components incorporated herein will be omitted when they may make the subject matter of the present invention unclear.

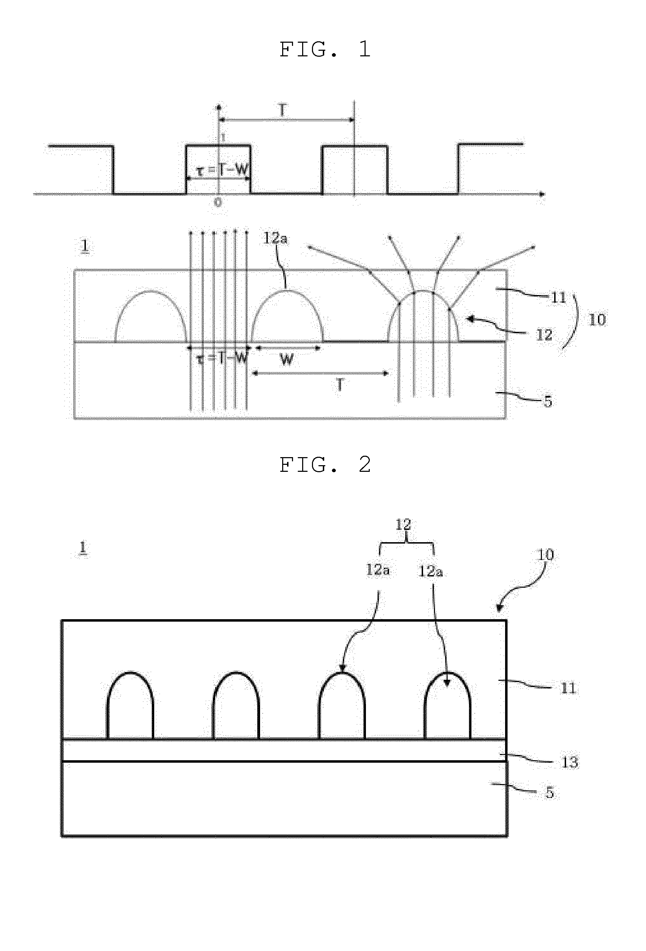

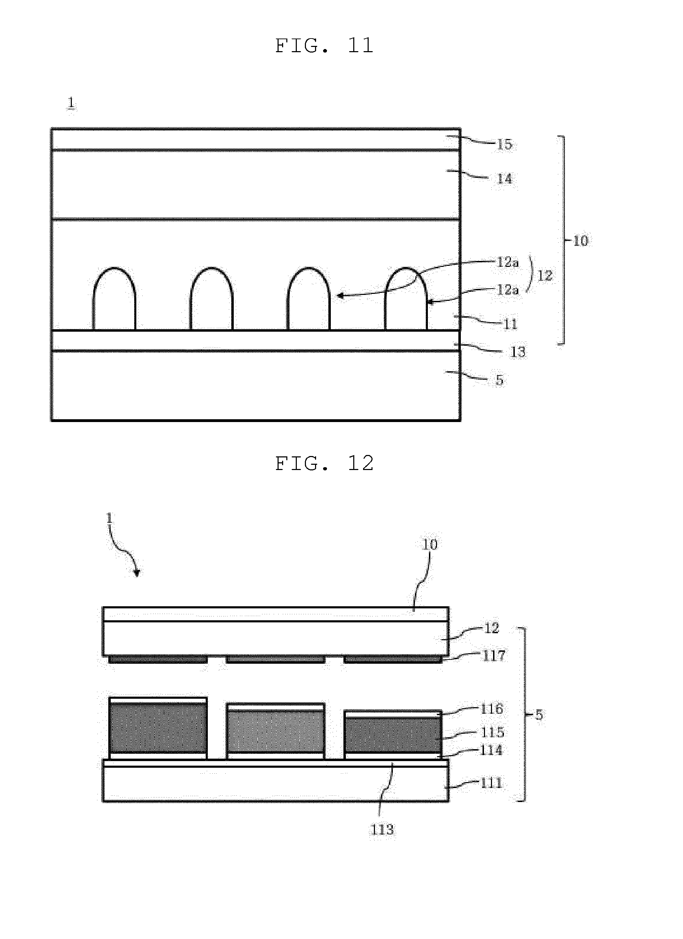

Referring to FIG. 1, an optical film 10 according to an exemplary embodiment of the invention is a film that is devised to prevent a moiré phenomenon while reducing color shift in a display device 1. In an example, the display device 1, which employs the optical film 10, may be a liquid crystal display. Here, the optical film 10 may be disposed on the front surface of a liquid crystal display panel 5, which has a liquid crystal layer interposed between two opposing substrates. In another example, the display device 1, which employs the optical film 10 of this embodiment, may be an organic light-emitting display. Here, the optical film is disposed on the front surface of an organic light-emitting display panel 5, i.e. one surface of the organic light-emitting display panel 5 in the direction in which light generated by an organic light-emitting device is emitted. Here, describing the organic light-emitting display panel 5 of the organic light-emitting display device 1, the organic light-emitting display panel 5 may be formed of a micro-cavity structure in order to improve the light efficiency thereof. In this case, the organic light-emitting display panel 5 is provided with a number of organic light-emitting devices, each of which generates red, green, blue or white light. In this micro-cavity structure of the organic light-emitting display panel 5, as shown in FIG. 12, when a unit pixel is the organic light-emitting display panel 5 that has red, green and blue organic light-emitting devices, the distance between an anode 114 and a cathode 116 of a red organic light-emitting device that generates a long wavelength is the longest, while the distance between the anode 114 and the cathode 116 of a blue organic light-emitting device that generates a short wavelength is the shortest. That is, the organic light-emitting display panel 5 forms the distance between the anode 114 and the cathode 116 such that it matches the respective major wavelengths of red light, green light and blue light. Consequently, only the corresponding light resonates and exits to the outside, while the other light is weakened.

When the organic light-emitting display panel 5 having the micro-cavity structure is formed in this way, the strength and the sharpness of light that is emitted are increased compared to those of light that is emitted from a common structure. This means that the overall luminance and color-reproducing ability of the organic light-emitting display panel 5 are improved.

The unit pixel of the organic light-emitting display panel 5 may include a gate line, a data line perpendicularly intersecting the gate line, a switching thin-film transistor (TFT) connected to the gate line and the data line, a drive TFT connected to an organic light-emitting device between the switching TFT and a power line, and a storage capacitor connected between a gate electrode of the drive TFT and the power line.

Here, the switching TFT supplies a data signal from the data line to the gate electrode of the drive TFT and the storage capacitor, in response to a scan signal from the gate line. The drive TFT controls the brightness of the organic light-emitting device by adjusting the amount of current that is supplied to the organic light-emitting device from the power line, in response to the data signal from the switching TFT. In addition, the storage capacitor receives the data signal from the switching TFT, and supplies a charged voltage to the drive TFT, so that the drive TFT can supply a constant voltage when the switching TFT is turned off.

In addition, this organic light-emitting display panel 5 may be implemented as an active matrix type, which is suitable for displaying a dynamic image, since it individually drives three color (red, green, blue) sub-pixels, which constitute the unit pixel. Consequently, each sub-pixel of the organic light-emitting display panel 5 may include an organic light-emitting device and a drive circuit section 113. The organic light-emitting device is disposed between first and second opposing substrates 111 and 112, and includes the anode 114, an organic light-emitting layer 115 and the cathode 116. The drive circuit section 113 is formed on the first substrate 111, and is electrically connected to the anode 114 and the cathode 116.

The anode 114 may be made of a metal or a metal oxide, such as Au, In, Sn or indium tin oxide (ITO), which has a large work function, such that holes can be efficiently injected. The cathode 116 may be formed such that it has a multilayer structure, which includes a semitransparent electrode of a metal thin film made of Al, Al:Li or Mg:Ag, which has a small work function such that electrons can be efficiently injected, and a transparent electrode of an oxide thin film made of ITO or the like, which efficiently transmits light that is generated.

As described above, the drive circuit section 113 may include at least two TFTs and capacitors, and controls the brightness of the organic light-emitting device by controlling the amount of current supplied to the organic light-emitting device in response to a data signal.

The organic light-emitting layer 115 of the organic light-emitting device includes a hole injection layer, a hole carrier layer, a light-emitting layer, an electron carrier layer and an electron injection layer, which are sequentially stacked on the anode 114. Due to this structure, when a forward voltage is applied between the anode 114 and the cathode 116, electrons migrate from the cathode 116 to the light-emitting layer via the electron injection layer and the electron carrier layer, and holes migrate from the anode 114 to the light-emitting layer via the hole injection layer and the hole carrier layer. Electrons and holes, which are injected into the light-emitting layer, are recombined in the light-emitting layer, thereby generating excitons, which emit light via transition from the excited state to the ground state. The brightness of light is proportional to the amount of current that flows between the anode 114 and the cathode 116.

In addition, the organic light-emitting display panel 5 includes color filters 117 in order to improve color efficiency. The color filters 117 are formed on the second substrate 112, and include red color filters on red sub-pixel areas, green color filters on green sub-pixel areas, and blue color filters on blue sub-pixel areas. When a unit pixel is composed of four colors (red, green, blue and white), the color filter 117 may be omitted from the white sub-pixel area.

Although not shown in the figures, the second substrate 112 may be provided with a black matrix, which prevents light leakage and color mixing, on the boundary of each sub-pixel. In addition, contact lines may be formed for the electrical connection between the drive circuit section 113 and the cathode 116 and the electrical connection between the anode 114 and the drive circuit section 113. Such electrical connection may be carried out via face-to-face bonding between the first substrate 111 and the second substrate 112 using a sealing material.

When the organic light-emitting display device 1 is formed as a front emission type, it is possible to prevent the light-blocking phenomenon due to the TFT, which would occur in the case of backside emission, thereby realizing higher light efficiency.

In this way, the optical film 10 according to an embodiment of the invention, which is employed in a variety of display devices 1, such as an LCD or an organic light-emitting display, includes a background layer 11 and a lens section 12.

The background layer 11 is disposed on the front surface of the display panel 5. The lens section 12 is formed in the background layer 11 by patterning. The background layer 11 is formed as a layer of light-transmitting material. The light-transmitting material may be a transparent polymer resin. In particular, the background layer 11 may be made of ultraviolet (UV)-curable transparent resin among types of the transparent polymer resin. The background layer 11 may be formed to a thickness of about 100μm.

When the optical film 10 is disposed in front of the display panel 5, i.e. the optical film 10 is spaced a predetermined distance apart from the display panel 5 while facing the display panel 5, a ghost may occur. The ghost not only distorts images on the display panel 5 but also creates hazing by causing external light incident on the optical film 10 and the display panel 5 to be reflected, one or multiple times, from the interface between the optical film 10 and the air (the air between the optical film 10 and the display panel 5) and from the interface between the air and the display panel 10, to be incident on the lens section 12, and then to diffuse. This ghosting becomes a factor that decreases the bright-room contrast ratio (BRCR), thereby reducing the visibility of the display device 1.

In order to solve this, in an embodiment of the invention, the optical film 10 is formed in close contact with the front surface of the display panel 5. As shown in the figure, the background layer 11 may be formed of a material that has an adhesive property. Here, the adhesive background layer 11 may be made of UV-curable transparent elastomer. Available examples for the transparent elastomer may include, but are not limited to, acrylic elastomer, silicone-based elastomer (polydimethylsiloxane: PDMS), urethane-based elastomer, polyvinyl butyral (PVB) elastomer, ethylene vinyl acetate (EVA)-based elastomer, polyvinyl ether (PVE)-based elastomer, saturated amorphous polyester-based elastomer, melamine resin-based elastomer, and the like. In addition, it is also possible to reduce the ghosting and hazing and increase the transmittance by simply bringing the optical film 10 into contact with the front surface of the display panel 5 instead of directly attaching the optical film 10 to the front surface of the display panel 5. Here, the optical film 10 must of course be completely in close contact with the display panel 5 such that an air gap is not formed in the contact surface between the optical film 10 and the display panel 5.

As shown in FIG. 2, the background layer 11 may be adhered to the display panel 5 via an adhesive 13, which has the same refractive index as the background layer 11. Available examples for the adhesive 13 may include, but are not limited to, acrylic adhesives, silicone-based adhesives, urethane-based adhesives, polyvinyl butyral (PVB) adhesives, ethylene vinyl acetate (EVA)-based adhesives, polyvinyl ether (PVE), saturated amorphous polyester, melamine resins, and the like.

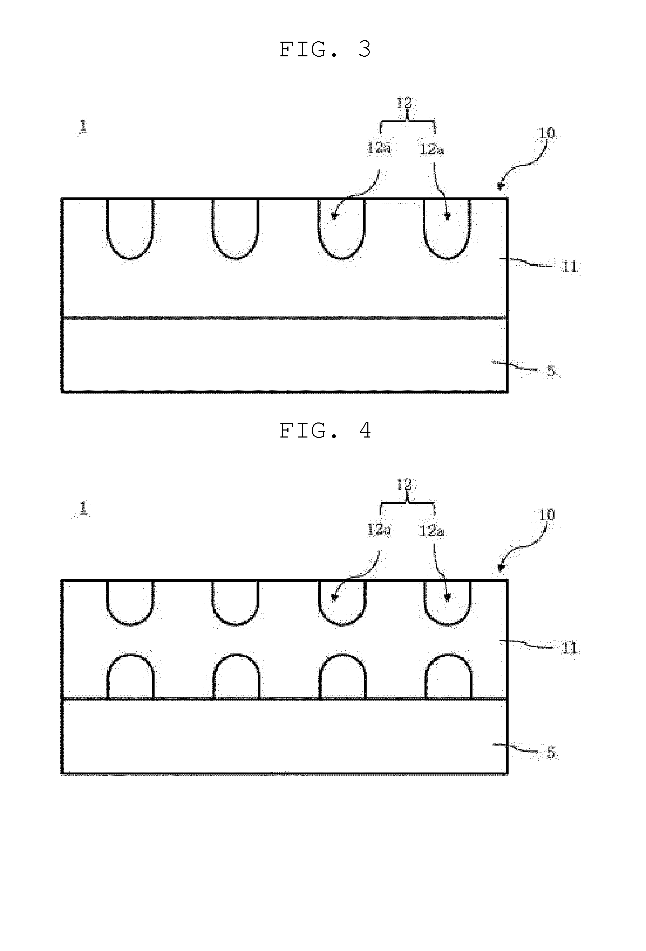

The lens section 12 is defined as a plurality of patterns 12a which refracts incident light, thereby minimizing color shift. The lens section 12 is also defined as a plurality of patterns 12a which reduces degradation in image quality due to a moiré phenomenon. The lens section 12 is formed in the background layer 11. As shown in the figures, the lens section 12 may be formed in one surface of the background layer 11 that faces the display panel 5, i.e. the rear surface of the background layer 11. However, as shown in FIG. 3, the lens section 12 may be formed in the front surface of the background layer 11, i.e. one surface of the background layer 11 that faces a viewer. In addition, as shown in FIG. 4, the lens section 12 may be formed in both surfaces of the background layer 11, i.e. both the front surface and the rear surface of the background layer 11.

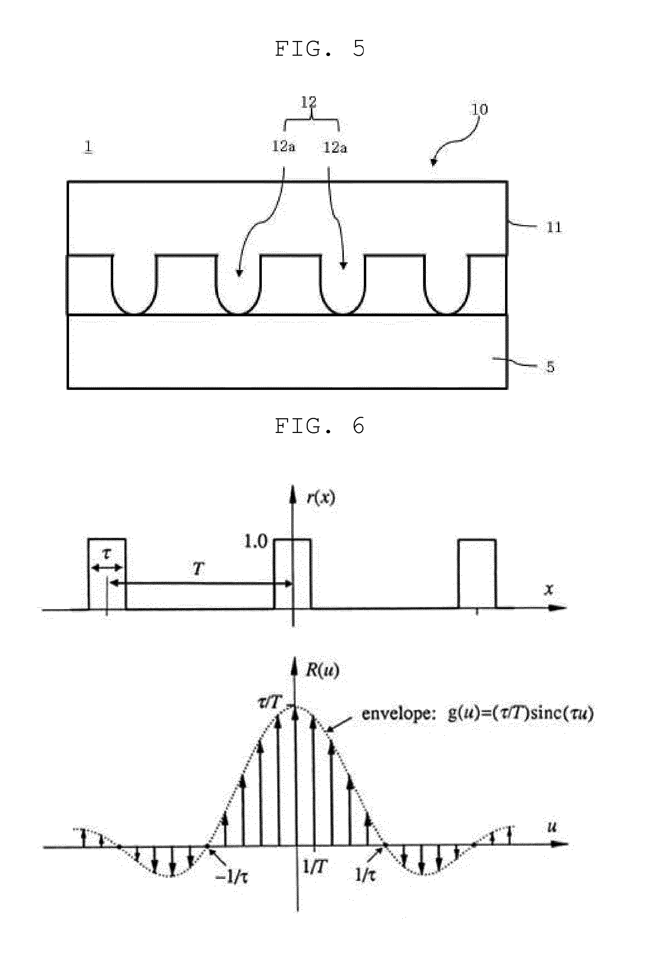

The lens section 12 may be formed as a plurality of engraved patterns 12a that has a predetermined depth into the background layer 11. However, as shown in FIG. 5, the s sections 12 may also be formed as a plurality of raised patterns that protrude from one surface of the background layer 11. The patterns 12a of the lens section 12 may be formed in the rear surface of the background layer 110 such that they are spaced apart from each other and are parallel to each other.

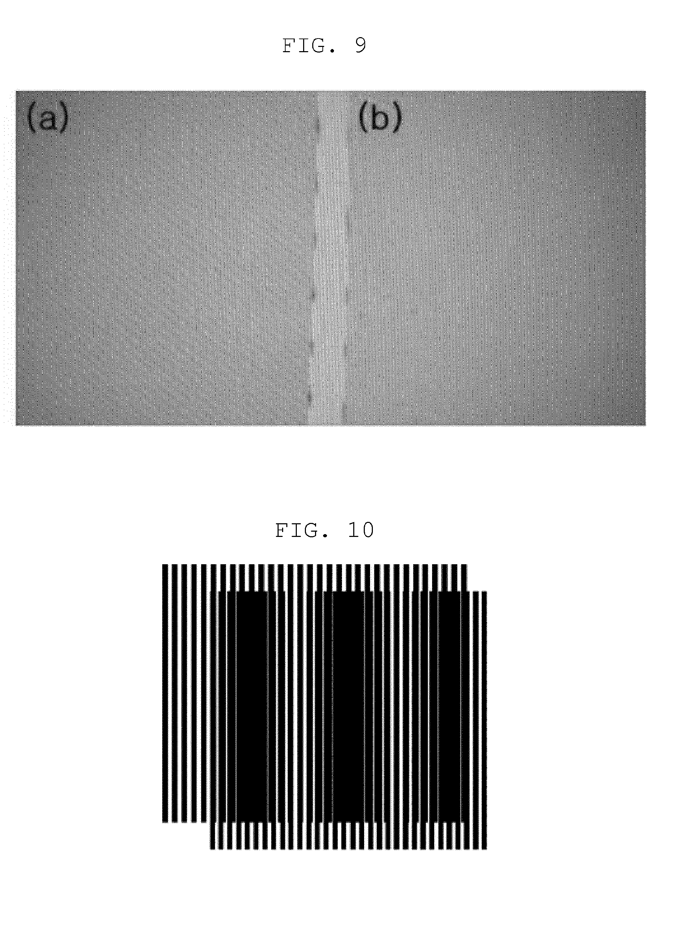

Here, as shown in FIG. 10, when the patterns 12a that have different pitches or periods overlap, a pattern that has a larger period than the existing patterns occurs. In this way, the phenomenon in which overlapping periodic patterns form a pattern that has a larger period than the original patterns 12a is referred to as a moiré, and the pattern formed thereby is referred to as a moiré pattern. The moiré degrades the image quality when it is created by the sub-pixel pattern of the display panel 5 and the pattern of the optical film 10. Therefore, in order to prevent the moiré phenomenon, the lens section 12 is formed to have a predetermined bias angle with respect to the edge of the background layer 11 in the related art. In an example, stripes of a stripe pattern are formed at a predetermined angle of inclination with respect to the horizontal or vertical direction. However, when the optical film 10 is cut into the shape of a rectangle in the same size as the display panel 5 after the lens section 12 is formed at a predetermined bias angle, the amount of the optical film 10 to be discarded is increased, thereby increasing the manufacturing cost.

Accordingly, in an embodiment of the invention, the optimal parameter of the patterns 12a of the lens section 12, which is formed in/on the background layer 11 is calculated using a formula derived from the Fourier series.

As shown in FIG. 1, when light is vertically incident on the optical film 10, of which the patterns 12a have a pitch T, a portion of the light that is incident on each pattern 12a having a width W is emitted in a different direction due to refraction, but a portion of the light that is incident on each interval between the patterns 12a, i.e. the flat surface ($\tau$ = T-W), passes through the optical film 10. Therefore, the front transmittance r(x) of the optical film 10 can be plotted in the shape of a rectangular wave, as approximately shown in the figure.

As shown in FIG. 6, the front transmittance r(x) of the optical film 10, in which the pitch is T, and the length of the portion through which light passes is $\tau$, is expressed using the Fourier series as in the following formulae.

$$r(x) = a_0 + 2\sum_{n=1}^{\infty} a_n \cos(2\pi nx/T) + 2\sum_{n=1}^{\infty} b_n \sin(2\pi nx/T)$$

$$a_0 = \frac{\tau}{T}$$

$$a_n = \frac{1}{n\pi} sin(\frac{\pi n \tau}{T}) = \frac{\tau}{T} sinc(\frac{n\tau}{T})$$

$$b_n = 0$$

$$r(x) = a_0 \left(1 + 2\sum_{n=1}^{\infty} \frac{a_n}{a_0} cos(2\pi \cdot n \cdot x/T)\right)$$

$$\frac{a_n}{a_0} = \frac{sin(\pi \cdot n \cdot \tau/T)}{(\pi \cdot n \cdot \tau/T)}$$

Here, when the pitch of the sub-pixels of the display panel 5 is P, and the length of the portion through which light is emitted is p, the intensity of light that passes through the optical film 10 is given as in the following formulae.

$$I = a_0^T \left(1 + 2\sum_{n=1}^{\infty} \frac{a_n^T}{a_0^T} cos(2\pi \cdot n \cdot x/T)\right) \cdot a_0^P \left(1 + 2\sum_{m=1}^{\infty} \frac{a_m^P}{a_0^P} cos(2\pi \cdot m \cdot x/P)\right)$$

$$a_0^T = \frac{\tau}{T}, \quad a_0^P = \frac{p}{P}, \quad \frac{a_n^T}{a_0^T} = \frac{sin(\pi \cdot n \cdot \tau/T)}{(\pi \cdot n \cdot \tau/T)}, \quad \frac{a_m^P}{a_0^P} = \frac{sin(\pi \cdot m \cdot p/P)}{(\pi \cdot m \cdot p/P)}$$

Arranging the above formulae leads to the following formula.

$$I = a_0^T a_0^P \left(1 + 2\sum_{n=1}^{\infty} \frac{a_n^T}{a_0^T} cos(\frac{2\pi \cdot n}{T} \cdot x) + 2\sum_{m=1}^{\infty} \frac{a_m^P}{a_0^P} cos(\frac{2\pi \cdot m}{P} \cdot x)\right.$$

$$+ 4\sum_{n=1}^{\infty}\sum_{m=1}^{\infty} \frac{a_n^T}{a_0^T} \frac{a_m^P}{a_0^P} cos(\frac{2\pi \cdot n}{T} \cdot x) cos(\frac{2\pi \cdot m}{P} \cdot x))$$

$$= a_0^T a_0^P \left(1 + 2\sum_{n=1}^{\infty} \frac{a_n^T}{a_0^T} cos(\frac{2\pi \cdot n}{T} \cdot x) + 2\sum_{m=1}^{\infty} \frac{a_m^P}{a_0^P} cos(\frac{2\pi \cdot m}{P} \cdot x)\right.$$

$$+ 2\sum_{n=1}^{\infty}\sum_{m=1}^{\infty} \frac{a_n^T}{a_0^T} \frac{a_m^P}{a_0^P} (cos(2\pi(\frac{n}{T} - \frac{m}{P}) \cdot x) + cos(2\pi(\frac{n}{T} + \frac{m}{P}) \cdot x)))$$

Here, a visible moiré pattern is the case of the greatest wavelength. From each term, the wavelength is expressed as follows.

$$T/n, P/m, \frac{1}{n/T - m/P}, \frac{1}{n/T + m/P}$$

Here, since each of n and m is an integer greater than 0, the greatest wavelength is given by the following formula that satisfies the condition $n/T—m/P\approx 0$.

$$\frac{1}{n/T - m/P}$$

Therefore, omitting the terms other than the term having the greatest wavelength, an approximate formula can be produced as follows.

$$I \approx a_0^T a_0^P \left(1 + 2\frac{a_n^T}{a_0^T}\frac{a_m^P}{a_0^P}\cos\left(2\pi\left(\frac{n}{T} - \frac{m}{P}\right)\cdot x\right)\right)$$

Here, the period $\lambda$ of the moiré pattern is given by the following formula.

$$\lambda = \frac{1}{n/T - m/P}$$

Here, the difference between the maximum value and the minimum value of light of the moiré pattern having the greatest wavelength must be very small in order for the moiré pattern to be invisible. Specifically, the modulation value of the intensity I of light that is defined by the following formula must be very small, and the moiré pattern is substantially invisible when the difference is 0.01 or less. This is expressed by the following formulae.

$$\frac{I_{max} - I_{min}}{I_{max} + I_{min}} \le 0.01$$

$$\frac{I_{max} - I_{min}}{I_{max} + I_{min}} = \left|\frac{(a_0^T a_0^P + 2a_n^T a_m^P) - (a_0^T a_0^P - 2a_n^T a_m^P)}{(a_0^T a_0^P + 2a_n^T a_m^P) + (a_0^T a_0^P - 2a_n^T a_m^P)}\right| = \left|\frac{2a_n^T a_m^P}{a_0^T a_0^P}\right|$$
$$= \left|2\frac{\sin(\pi\cdot n\cdot \tau/T)}{(\pi\cdot n\cdot \tau/T)}\frac{\sin(\pi\cdot m\cdot p/P)}{(\pi\cdot m\cdot p/P)}\right| \le 0.01$$

$$n/T - m/P \approx 0, n/T \approx m/P$$

In the following formula:

$$\frac{I_{max} - I_{min}}{I_{max} + I_{min}} \approx \left|2\frac{\sin(\pi\cdot m\cdot \tau/P)}{(\pi\cdot m\cdot \tau/P)}\frac{\sin(\pi\cdot m\cdot p/P)}{(\pi\cdot m\cdot p/P)}\right|,$$

it is considered that n = 1, i.e. 1/T ≒ m/P, and k is defined as $k = \frac{\tau/T}{p/P}$.

The above formula is simply arranged as follows.

$$\frac{I_{max} - I_{min}}{I_{max} + I_{min}} \approx \left|2\frac{\sin(\pi \cdot \tau/T)}{(\pi \cdot \tau/T)}\frac{\sin(\pi \cdot m \cdot p/P)}{(\pi \cdot m \cdot p/P)}\right|$$

$$= \left|2\frac{\sin(\pi \cdot (\tau/T)/(p/P) \cdot (p/P))}{(\pi \cdot (\tau/T)/(p/P) \cdot (p/P))}\frac{\sin(\pi \cdot m \cdot p/P)}{(\pi \cdot m \cdot p/P)}\right|$$

$$= \left|2\frac{\sin(\pi \cdot k \cdot p/P)}{(\pi \cdot k \cdot p/P)}\frac{\sin(\pi \cdot m \cdot p/P)}{(\pi \cdot m \cdot p/P)}\right|$$

Here, k indicates the ratio of the aperture ratio $\tau/T$ of the optical film 10 to the aperture ratio p/P of the display panel 5.

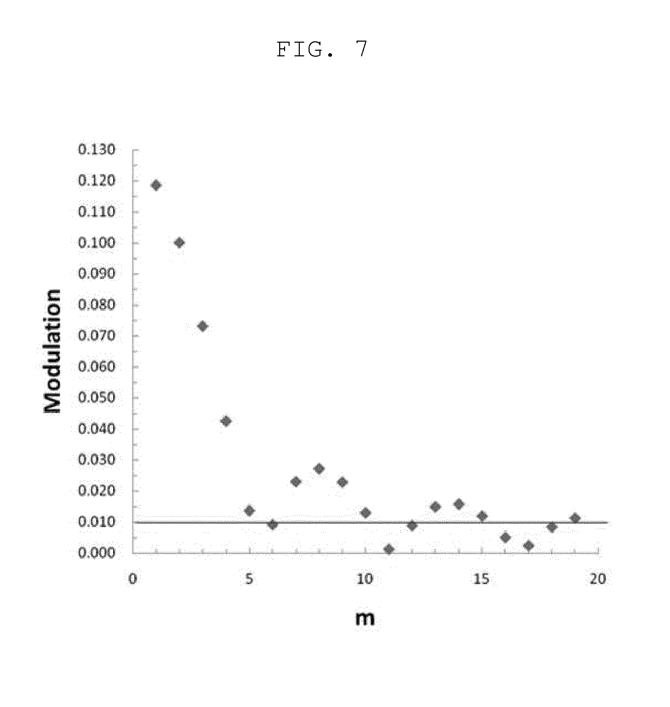

For example, in the case of a 46" (1018x574mm) full HD ((1920×3)×1080) LCD TV, the pitch of sub-pixels is 175μm and the aperture ratio p/P is 0.82. When an optical film 10 having an aperture ratio $\tau/T$ of 0.76 is used, k is 0.93. In this case, as shown in the graph of FIG. 7, the modulation value of the intensity of light is a function of a natural number m from the above formula. In FIG. 7, the modulation value is less than 0.01 when the moiré pattern is invisible, in which the value of m appears to be 6, 11, or the like. Since m is P/T and the pitch P of the sub-pixels is 175μm in the above definition, the pitch T of the patterns 12a of the optical film 10 is 29μm, which is 1/6 of the pitch P of the sub-pixels. In this case, the moiré pattern is invisible.

Table 1

| | Pattern width (W) | Pattern pitch (T) | Flat surface ($\tau$ = T-W) | Aperture ratio[*)] ($\tau$/T) | K = ($\tau$/T) (p/P) | M = P/T |
|---|---|---|---|---|---|---|
| Comp. Ex. | 21 | 88 | 67 | 0.76 | 0.93 | 2 |
| Example | 7.5 | 29 | 21.5 | 0.74 | 0.90 | 6 |
| Note) Aperture ratio[*)]: Aperture ratio of an optical film | | | | | | |

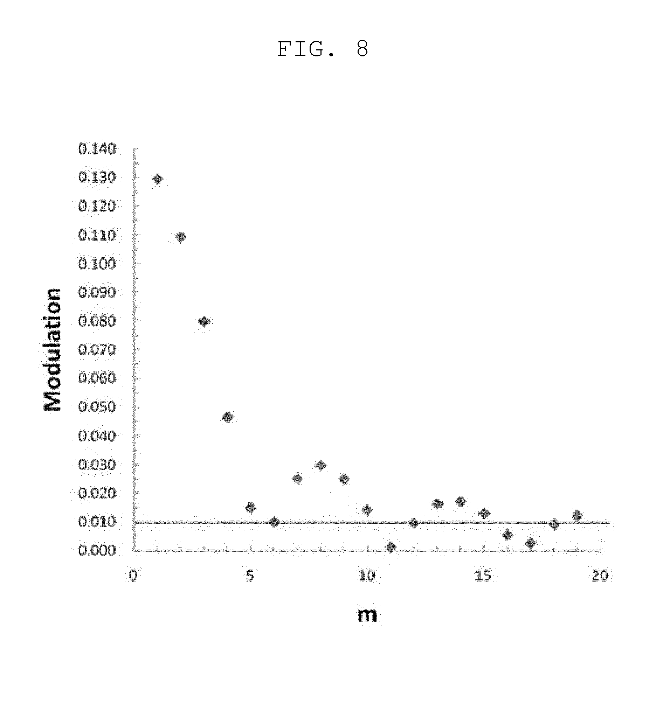

Table 1 above presents the parameters of the comparative example and the example when the sub-pixels of the display panel 5 have a pitch p of 175μm and an aperture ratio of p/P = 0.82. Here, FIG. 8 presents the modulation values depending on variation of m in the conditions of the example, in which the value of m 0.01 appears to be 6, 11, or the like when the modulation value is less than 0.01, i.e. the moiré pattern is invisible. That is, since the m value of the example is 6, this value belongs to the range of the m value in which moiré pattern is invisible.

FIG. 9 is a picture of an optical film (a) according to the comparative example, which has the parameters in Table 1, and an optical film (b) according to the example of the invention, which has the parameters in Table 1, the optical films (a) and (b) being attached to a display panel. As shown in the picture of FIG. 9, it can be appreciated that a moiré pattern is visible in the comparative example in which m is 2, whereas no moiré pattern is visible in the example in which m is 6. It can be verified that the result (FIG. 8) that is deduced from the formula derived from the Fourier series is identical with the actual application (FIG. 9).

Summarizing these results, general conditions under which no moiré is visible are as follows.

When the aperture ratio $\tau/T$ of the optical film 10 is determined by the pitch P and the aperture ratio p/P of the certain display panel 5, the range of m in which the following formulae are satisfied can be produced. From this, the pitch T, parameters, and the like of the patterns 12a of the optical film 10 can be determined.

$$\left|2\frac{\sin(\pi \cdot k \cdot p/P)}{(\pi \cdot k \cdot p/P)}\frac{\sin(\pi \cdot m \cdot p/P)}{(\pi \cdot m \cdot p/P)}\right| \leq 0.01$$

$$k = \frac{\tau}{p}\frac{T}{P}$$

The lens section 12, of which the pitch T of the patterns 12a is determined based on the above formulae, serves not only to prevent moiré but also to reduce color shift that occurs in response to an increase in the viewing angle using the color mixing effect.

Describing it in more detail, the lens section 12 changes the direction of the portion of light that is emitted perpendicular to the plane of the display panel 5 such that it is not perpendicular thereto and change the direction of the portion of light that is not originally emitted perpendicular thereto such that it is emitted perpendicular thereto. In this way, the lens section 12 can cause color mixing by changing the direction in which light is emitted depending on the viewing angle, thereby reducing color shift. Here, the spacing τ between the patterns 12a of the lens section 12 may be formed to be greater or wider than the width W of each pattern 12a. This makes it possible to transmit more light that is emitted perpendicular to the plane of the display panel 5.

As shown in FIG 1, the cross-section of the patterns 12a of the lens section 12 may have a shape including an arc of an ellipse. The patterns 12a may have a shape selected from among, but not limited to, stripes having a wedge-shaped cross-section, waves having a wedge-shaped cross-section, a matrix having a wedge-shaped cross-section, a honeycomb having a wedge-shaped cross-section, dots having a wedge-shaped cross-section, stripes having a quadrangular cross-section, waves having a quadrangular cross-section, a matrix having a quadrangular cross-section, a honeycomb having a quadrangular cross-section, dots having a quadrangular cross-section, stripes having a semicircular cross-section, waves having a semicircular cross-section, a matrix having a semicircular cross-section, a honeycomb having a semicircular cross-section, dots having a semicircular cross-section, stripes having a semi-elliptical cross-section, waves having a semi-elliptical cross-section, a matrix having a semi-elliptical cross-section, a honeycomb having a semi-elliptical cross-section, dots having a semi-elliptical cross-section, stripes having a semi-oval cross-section, waves having a semi-oval cross-section, a matrix having a semi-oval cross-section, a honeycomb having a semi-oval cross-section, and dots having a semi-oval cross-section. Here, the term "wedge-shaped cross-section" may be a trapezoidal or triangular cross-section. In addition, the term "semi-oval cross-section" may have a parabolic profile. Further, the terms "semicircular cross-section," "semi-elliptical cross-section," and "semi-oval cross-section" are not limited to the shapes that are obtained by dividing circular, elliptical, or oval shapes precisely into two sections, but include shapes in which part of the outline of the cross-section of the patterns 12a of the lens section 12 includes an arc, an elliptical arc, or a parabola. That is, the "semi-elliptical cross-section" may have a shape that has two elliptical arc lateral sides and a linear top (bottom). However, the patterns 12a of the lens section 12 are not limited to the above-described shapes, but may have a variety of shapes. In an example, the pattern comprising stripes may also include a variety of patterns, such as a horizontal stripe pattern, a vertical stripe pattern, and the like.

When the patterns 12a are formed in the horizontal direction, they are effective in compensating for vertical viewing angles. When the patterns 12a are formed in the vertical direction, they are effective in compensating for horizontal viewing angles. Here, it is preferred that the cross-section of the patterns 12a of the lens section 12 be laterally symmetrical.

The degree of color shift Δu'v' that is discernible with the human eye is 0.004 or greater. The display panel 5 (a super-in-plane switching (S-IPS) panel having the best color shift characteristics) exhibits a maximum color shift Δu'v' of 0.02 at viewing angles ranging from 0 degrees to 60 degrees. Therefore, the magnitude of color shift reduction is required to be 20% or greater, that is, the maximum Δu'v' is required to be 0.016 or less in order to attain a reduction in color shift that is discernible with the human eye. In order to realize this, according to an embodiment of the invention, the patterns 12a of the lens section 12 can be configured such that the ratio of the depth to the width W of the patterns 12a be 0.25 or less. In addition, in order to realize the magnitude of color shift reduction of 20% or greater, the patterns 12a can be configured such that the ratio of spacing τ to the pitch T of the patterns 12a be 0.95 or less. The transmittance of the optical film 10 increases in response to an increase in the ratio of the spacing τ to the pitch T of the patterns 12a. The optical film 10 is viable as a commercial product when the light transmittance thereof is 50% or greater. Here, the ratio of spacing τ to the pitch T of the patterns 12a is required to be 0.5 or greater in order for the transmittance of optical film 10 to be 50% or greater. It is preferred that the patterns 12a be configured such that the ratio of spacing τ to the pitch T of the patterns 12a ranges from 0.5 to 0.95.

In order not only to remove or prevent the moiré but also to prevent the ghosting, the optical film 10 is formed such that it is in close contact with the front surface of the display panel, and it is required for the pitch T of the patterns 12a to be controlled. Thus, it is preferred that the pitch T of patterns 12a be 45μm or less in the condition that the ratio of the spacing τ to the pitch T of the patterns 12a is satisfied. It is of course required for the range of the pitch T to satisfy the value of the pitch T determined by the m value deduced from the formula that is derived from the Fourier series. If the patterns 12a having a pitch size of 0.01 μm or less are present, the effect is insignificant, since they act like a thin film that has a refractive index midway between the refractive index of the optical film 10 and the refractive index of the air rather than realizing the color mixing due to reflection, refraction, and scattering of light. Therefore, it is preferred that the pitch of the patterns 12a be 0.01 μm or greater.

A method of preparing the lens section 12 includes applying a UV-curable resin on one surface of, for example, a backing 14 shown in FIG. 11, and then forming the patterns 12a in the UV-curable resin using a forming roll that has a pattern that is the reverse of that of the lens section 12 while radiating UV rays onto the UV-curable resin. Finally, the background layer 11 in which the lens section 12 having the plurality of patterns 12a is formed is prepared. However, the present invention is not limited thereto, but the plurality of patterns 12a of the lens section 12, which is formed in the background layer 11, may be formed by a variety of methods, such as thermal pressing, which uses thermoplastic resin, injection molding, in which thermoplastic resin or thermosetting resin is injected, or the like.

Although not shown, in an embodiment of the invention, the optical film 10 may be provided with a resin layer. If the concave portions of the patterns of the optical film in the related art are formed as an air gap, transmittance is low because light incident onto the patterns is diffused to a high angle, thereby making the efficiency of reducing color shift insignificant at a low angle, and is totally reflected on the optical film, thereby making the efficiency of reducing color shift insignificant. In order to reduce this problem, the resin layer can be disposed in the concave portions of the patterns 12a. In addition, if the concave portions of the patterns are formed as an air gap, when external pressure is applied after the optical film is attached to the display panel 5 via the adhesive 13, the air gap may be formed in the adhesive 13, thereby causing a defective appearance. In order to reduce this problem, the resin layer may be disposed in the concave portions of the patterns 12a. The resin layer may also be disposed in the concave portions of the patterns 12a in order to reduce the problem in that stripe-shaped defects occur in the patterns due to penetration of moisture when the optical film in which the concave portions of the patterns are formed as an air gap is left in the environment that has a temperature of 60°C and relative humidity of 90%. Thus, the resin layer according to an embodiment of the invention may be disposed in the space between the display panel 5 and the structure including the lens section 12 and the background layer 11. Here, the resin layer can be disposed only in the concave portions of the engraved patterns 12a. In this case, however, after the resin layer is disposed in the concave portions, planarization processing is required in order to make the surface of the resin layer be flush with the rear surface of the background layer 11. Therefore, when the resin layer is formed by disposing resin in the concave portions of the patterns 12a and is also formed between the display panel 5 and the background layer 11, it is possible to omit the planarization processing on the surface of the resin layer.

When the patterns 12a of the lens section 12 are formed as raised portions, the resin layer may be disposed in the space between the raised patterns.

The resin layer may be made of a material that has a refractive index $n_2$ different from the refractive index $n_1$ of the background layer 11. Although the refractive index $n_1$ of the background layer 11 may be greater or smaller than the refractive index $n_2$ of the resin layer, it is preferred that the refractive index $n_1$ of the background layer 11 be smaller than the refractive index $n_2$ of the resin layer. It is preferred that the difference in refractive index $\Delta n = |n_1 - n_2|$ between the background layer 11 and the resin layer be 0.1 or greater.

In addition, as shown in FIG. 11, in an embodiment of the invention, the optical film 10 may be provided with the backing 14. The backing 14 is disposed on the front surface of the background layer 11, and serves to support the background layer 11. The backing 14 may be made of a transparent resin film or a glass substrate that is UV transparent. Available materials for the backing may include, but are not limited to, polyethylene terephthalate (PET), polycarbonate (PC), polyvinyl chloride (PVC) and triacetate cellulose (TAC).

In an embodiment of the invention, the optical film 10 may be provided with an anti-reflection layer 15. The anti-reflection layer 15 is formed on the front surface of the backing, and serves to reduce the reflection of external light that is incident thereon. The anti-reflection layer 15 may be omitted when the backing 14 is made of a material that reduces reflection of light. The anti-reflection layer 15 may be formed as a film, which is attached to the front surface of the backing 14. The anti-reflection layer 15 may be formed as a single layer of fluorine-based transparent polymer resin, magnesium fluoride, silicon-based resin, silicon oxide, or the like, which has a low refractive index of 1.5 or less, preferably, 1.4 or less in the visible light range. In addition, the anti-reflection layer 15 may be formed as a thin film by stacking multiple layers, for example, two or more layers having different refractive indexes. Available materials for the layers may include, but not limited to, inorganic compounds, such as metal oxides, fluorides, silicides, borides, carbides, nitrides, sulfides, and the like; and organic compounds, such as silicon-based resins, acrylic resins, fluorine-based resins, and the like. For example, the anti-reflection layer 15 may be formed as a structure in which low-refractivity oxide films of, for example, $SiO_2$ and high-refractivity oxide films of, for example, $Nb_2O_5$ are stacked one on another in an alternating fashion.

Although the optical film 10 according to an embodiment of the invention may be formed as a single layer film that is composed of the background layer 11, it may also be formed as a multilayer film in which the background layer 11, the backing 14 and the anti-reflection layer 15 are stacked one on another. When the background layer 11 is formed as a multilayer film, various functional films including an anti-fog film, a polarizer film, a phase retardation film, and the like may be stacked one on another in addition to the backing 14 and the anti-reflection layer 15.

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

**Claims**

1.  A display device comprising a display panel (5) and an optical film (10), wherein the optical film (10) comprises:

    a background layer (11) disposed in front of the display panel (5); and
    a lens section (12) formed on the background layer (11), the lens section (12) having a plurality of engraved or raised patterns (12a) spaced apart from each other and being adapted to diffuse incident light,

    wherein a spacing ($\tau$) between the plurality of engraved or raised patterns (12a) and a pitch (T) of the plurality of engraved or raised patterns (12a) satisfy the following conditions (1) to (3):

    (1)
    $$\left| 2\frac{\sin(\pi \cdot k \cdot \mathrm{p/P}) \sin(\pi \cdot \mathrm{m} \cdot \mathrm{p/P})}{(\pi \cdot k \cdot \mathrm{p/P})(\pi \cdot \mathrm{m} \cdot \mathrm{p/P})} \right| \le 0.01,$$

    (2)
    $$k = \frac{\tau/T}{p/P},$$

    and

    (3)
    $$m = P/T,$$

    wherein p/P is an aperture ratio of sub-pixels of the display panel (5), $\tau$/T is an aperture ratio of the lens section (12), P is a pitch of the sub-pixels, p is a width of the sub-pixels, T is the pitch of the plurality of engraved or raised patterns (12a), and $\tau$ is the spacing between the plurality of engraved or raised patterns (12a).

2.  The display device of claim 1,
    wherein the lens section (12) comprises the plurality of engraved patterns (12a), and
    the display device further comprises a resin filling the lens section (12), the resin having a refractive index different from a refractive index of the background layer (11).

3.  The display device of claim 2, wherein the refractive index of the background layer (11) is smaller than the refractive index of the resin.

4.  The display device of claim 3, wherein a difference between the refractive index of the background layer (11) and the refractive index of the resin is 0.1 or greater.

5.  The display device according to any one of the preceding claims, further comprising a resin layer coating the lens section (12) and a surface of the background layer (11) on which the lens section (12) is formed.

6.  The display device according to any one of the preceding claims, wherein the background layer (11) is made of a material that has an adhesive property in itself, and is directly attached to a front surface of the display panel (5).

7.  The display device according to any one of the preceding claims, wherein the background layer (11) is adhered to a front surface of the display panel (5) by an adhesive (13).

8.  The display device according to any one of the preceding claims, wherein the lens section (12) is formed on a rear surface of the background layer (11) that faces the display panel (5).

9.  The display device according to any one of the preceding claims, wherein a cross-section of the plurality of engraved or raised patterns (12a) has a shape including an arc of an ellipse.

10. The display device according to any one of the preceding claims, wherein the plurality of engraved or raised patterns (12) comprises a shape selected from the group consisting of stripes having a wedge-shaped cross-section, waves having a wedge-shaped cross-section, a matrix having a wedge-shaped cross-section, a honeycomb having a wedge-shaped cross-section, dots having a wedge-shaped cross-section, stripes having a quadrangular cross-section, waves having a quadrangular cross-section, a matrix having a quadrangular cross-section, a honeycomb having a quadrangular cross-section, dots having a quadrangular cross-section, stripes having a semicircular cross-section, waves having a semicircular cross-section, a matrix having a semicircular cross-section, a honeycomb having a semicircular cross-section, dots having a semicircular cross-section, stripes having a semi-elliptical cross-section, waves having a semi-elliptical cross-section, a matrix having a semi-elliptical cross-section, a honeycomb having a semi-elliptical cross-section, dots having a semi-elliptical cross-section, stripes having a semi-oval cross-section, waves having a semi-oval cross-section, a matrix having a semi-oval cross-section, a honeycomb having a semi-oval cross-section, and dots having a semi-oval cross-section.

11. The display device according to any one of the preceding claims, wherein the spacing (τ) between the plurality of engraved or raised patterns (12a) is greater than a width (W) of the plurality of engraved or raised patterns (12a).

12. The display device according to any one of the preceding claims, wherein a ratio of a depth to a width of the plurality of engraved or raised patterns (12a) ranges from 0.25 to 2.5.

13. The display device according to any one of the preceding claims, wherein a ratio of the spacing between (τ) the plurality of engraved or raised patterns (12a) to the pitch (T) of the plurality of engraved or raised patterns (12a) ranges from 0.5 to 0.95.

14. The display device according to any one of the preceding claims, wherein the pitch (T) of the plurality of engraved or raised patterns (12a) is 45μm or less.

15. The display device according to any one of the preceding claims, wherein the display panel (5) is a liquid crystal display panel, which comprises two opposing substrates and a liquid crystal layer interposed between the two opposing substrates, or
wherein the display panel (5) is an organic light-emitting display panel, which comprises organic light-emitting devices, each of the organic light-emitting devices generates one of red light, green light, blue light and white light, and the organic light-emitting device are formed at different heights depending on respective wavelengths of lights which the organic light-emitting devices generate.

FIG. 1

$\tau = T - W$

FIG. 2

FIG. 3

FIG. 4

FIG. 5

FIG. 6

envelope: $g(u) = (\tau/T)\mathrm{sinc}(\tau u)$

FIG. 7

FIG. 8

FIG. 9

FIG. 10

FIG. 11

FIG. 12

FIG. 13

off                                                          on

FIG. 14

FIG. 15

FIG. 16

FIG. 17

Europäisches
Patentamt

European
Patent Office

Office européen
des brevets

**EUROPEAN SEARCH REPORT**

Application Number

EP 12 16 9800

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 9 049925 A (SEKISUI CHEMICAL CO LTD) 18 February 1997 (1997-02-18) <br> * paragraphs [0023], [0029], [0031] * <br> * paragraphs [0036] - [0038], [0045], [0048] * <br> * abstract; figures 1-5 * <br> ----- | 1-15 | INV. <br> G02F1/1335 <br> G02B3/00 <br> H01L51/52 |
| A | US 2008/036759 A1 (KOIKE TAKAFUMI [JP] ET AL) 14 February 2008 (2008-02-14) <br> * paragraphs [0005], [0007], [0014], [0016] * <br> * paragraphs [0020], [0021], [0029], [0034] * <br> * paragraphs [0069], [0075] - [0079], [0082] * <br> * paragraphs [0085], [0086], [0092] - [0094] * <br> * paragraphs [0097], [0107] - [0110]; figures 5,7-9,11,12,14-20 * <br> ----- | 1-15 | |
| A | EP 0 846 974 A2 (SONY CORP [JP] SONY CORP) 10 June 1998 (1998-06-10) <br> * column 6, line 33 - column 7, line 45 * <br> * column 9, lines 11-13,41-58 * <br> * column 13, line 3; figures 2-4 * <br> ----- | 1-15 | TECHNICAL FIELDS SEARCHED (IPC) <br><br> G02F <br> G02B <br> H01L |

The present search report has been drawn up for all claims

| Place of search | Date of completion of the search | Examiner |
|---|---|---|
| Munich | 11 September 2012 | Wahl, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 12 16 9800

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2012

| Patent document cited in search report | | Publication date | Patent family member(s) | | Publication date |
|---|---|---|---|---|---|
| JP 9049925 | A | 18-02-1997 | NONE | | |
| US 2008036759 | A1 | 14-02-2008 | JP | 2008026654 A | 07-02-2008 |
| | | | US | 2008036759 A1 | 14-02-2008 |
| EP 0846974 | A2 | 10-06-1998 | DE | 69729625 D1 | 29-07-2004 |
| | | | DE | 69729625 T2 | 23-06-2005 |
| | | | EP | 0846974 A2 | 10-06-1998 |
| | | | ES | 2219740 T3 | 01-12-2004 |
| | | | JP | 3318859 B2 | 26-08-2002 |
| | | | JP | 10161097 A | 19-06-1998 |
| | | | US | 6002459 A | 14-12-1999 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020110051584
- KR 1020110060522